# FASCICULE DE BREVET EUROPEEN

(11) **EP 1 295 391 B1**
(45) Date de publication et mention de la délivrance du brevet: **18.10.2006**
(21) Numéro de dépôt: 01945402.4
(22) Date de dépôt: 12.06.2001
(51) Int. Cl.: H03J 5/24

(54) **DISPOSITIF DE FILTRAGE PASSE BANDE DE FREQUENCE AUTO ADAPTATIF DANS UN EMETTEUR/RECEPTEUR DE SIGNAUX HYPERFREQUENCES**
SELBSTABGLEICHENDE BANDPASSFILTERUNGSVORRICHTUNG IN EINEM SENDE-EMPFANGSGERÄT FÜR MIKROWELLENSIGNALE
SELF-ADAPTIVE FREQUENCY BAND-PASS FILTERING DEVICE IN MICROWAVE SIGNAL TRANSCEIVER

(30) Priorité: 26.06.2000 FR 0008165
(43) Date de publication de la demande: 26.03.2003
(73) Titulaire: Thomson Licensing, 92100 Boulogne-Billancourt (FR)
(72) Inventeur: GILBERTON, Philippe, F-92648 Boulogne Cedex (FR); DENIS, Bernard, F-92648 Boulogne Cedex (FR)
(74) Mandataire: Cour, Pierre
(86) Numéro de dépôt international: PCT/FR2001/001816
(87) Numéro de publication internationale: WO 2002/001718

(56) Documents cités:
- EP-A- 0 668 656
- EP-A- 0 818 888
- FR-A- 2 386 191
- US-A- 4 464 639

## Description

La présente invention concerne un dispositif de filtrage passe bande de fréquence auto adaptatif dans un émetteur/récepteur de signaux hyperfréquences utilisé notamment pour déployer un réseau domestique numérique sans fil. Ce type de réseau est basé sur la transmission et la réception d'informations par l'intermédiaire de radiofréquences du type hyperfréquences.

Il est connu dans l'art antérieur par la demande de brevet britannique GB 2335100, un dispositif permettant d'accorder continûment un filtre passe-bande de fréquence étroit sur la fréquence du signal incident, correspondant à un canal de réception donné. Ce filtre, disposé entre un amplificateur à faible bruit et un mélangeur, permet de rejeter le spectre image qui est issu de l'amplificateur et évite ainsi d'utiliser un mélangeur à réjection de spectre image plus délicat à mettre au point. Le filtre doit donc être caractérisé par une bande de fréquence étroite correspondant à la bande de fréquence nécessaire du canal à transmettre. L'information sur la fréquence permettant d'ajuster le filtre est prise en amont du filtre par l'intermédiaire d'un coupleur, de façon à asservir le filtre à l'éventuelle dérive en fréquence du signal incident et de ne pas sortir ainsi de sa bande de fréquence étroite. Cependant, l'asservissement du filtre sur chaque canal ne peut se faire que par la connaissance préalable de la fréquence que le dispositif reçoit. Par conséquent, le dispositif décrit dans cette demande de brevet n'est opérationnel que dans le cas d'une liaison déjà établie.
Le document Sharp EP-A- 668 656 concerne un dispositif haute fréquence comprenant un circuit tuner qui comporte une paire de filtres passe bande associée à des commutateurs de sélection déterminant ainsi un mode de réception bande haute et un mode bande basse. Les moyens de sélection de ces commutateurs sont issus d'un circuit de commande 17 et dépendent de la fréquence du signal à sélectionner.

Cet objectif est atteint par un dispositif de filtrage passe bande auto adaptatif dans un émetteur et/ou récepteur de signaux hyperfréquences, le récepteur étant relié à une antenne de réception de signaux hyperfréquences connectée sur l'entrée d'un amplificateur à faible bruit, un mélangeur recevant d'une part le signal de sortie de l'amplificateur faible bruit, et d'autre part le signal d'un synthétiseur de fréquence, caractérisé en ce que le dispositif de filtrage auto adaptatif comprend en amont de l'amplificateur, d'une part au moins un moyen de filtrage à au moins deux bandes de fréquence différentes, et d'autre part des moyens de sélection soit d'un moyen de filtrage, soit de l'une des bandes de fréquence en fonction de la fréquence du signal à recevoir.

Selon une autre particularité, les moyens de filtrage comprennent deux filtres et les moyens de sélection comprennent une paire de commutateurs hyperfréquence entre deux états et disposée de part et d'autre de chaque filtre passe bande, de sorte que dans un premier état de la paire de commutateurs, le signal reçu par l'antenne est filtré par le premier filtre et dans un deuxième état de la paire de commutateurs, le signal reçu par l'antenne est filtré par le deuxième filtre.

Selon une autre particularité, les deux filtres sont respectivement destinés au filtrage d'une première et deuxième bandes de fréquence.

Selon une autre particularité, les moyens de filtrage comprennent un filtre à lignes microruban dont chaque ligne microruban est divisée en deux portions séparées, par les moyens de commutation, chaque première et deuxième portions de ligne microruban est de longueur déterminée pour que, lorsque les moyens de commutation autorisent le passage par couplage entre lignes microruban du signal reçu uniquement dans la première portion, le filtre soit accordé sur une première bande de fréquence et lorsque les moyens de commutation autorisent le passage par couplage entre lignes microruban du signal dans la première et la deuxième portions, le filtre soit accordé sur la deuxième bande de fréquence.

Selon une autre particularité, le changement d'état des commutateurs des moyens de sélection est déclenché par un moyen de commande associé au synthétiseur de fréquence de sorte que lorsque la fréquence imposée par le synthétiseur de fréquence est comprise dans une première bande de fréquence B1 des moyens de filtrage, le moyen de commande délivre un signal pour faire passer les commutateurs dans le premier état, et lorsque la fréquence imposée par le synthétiseur de fréquence est comprise dans une deuxième bande de fréquence B2 des moyens de filtrage, le moyen de commande délivre un signal pour faire passer les commutateurs dans le deuxième état.

Selon une autre particularité, le moyen de commande comprend un comparateur dont une première entrée est connectée au travers d'un étage tampon au synthétiseur de fréquence pour recevoir l'image convertie en tension de la fréquence produite par le synthétiseur de fréquence, et dont une deuxième entrée reçoit une tension de référence déterminée.

Selon une autre particularité, le moyen de commande comprend un comparateur dont une première entrée est connectée à un circuit de traitement destiné à fournir une image convertie en tension, soit de la fréquence générée par l'oscillateur contrôlé en tension, soit de la fréquence du signal hyperfréquence reçu par l'antenne.

Selon une autre particularité, le circuit de traitement comprend un comparateur phase/fréquence, dont une première entrée reçoit un signal généré par un oscillateur à fréquence fixe, la deuxième entrée du comparateur phase/fréquence est reliée à un commutateur commandé par le microprocesseur permettant de connecter la deuxième entrée, soit dans une première position, sur la sortie de l'oscillateur contrôlé en tension, soit dans une deuxième position, sur un coupleur fournissant une image de la fréquence des signaux reçus sur l'antenne, la deuxième entrée du comparateur reçoit une tension de référence déterminée.

Selon une autre particularité, chaque commutateur comprend une paire de diodes rapides montées en série, de sorte qu'une première paire de diodes soit montée entre l'antenne et les deux filtres et que la deuxième paire de diodes soit montée entre l'amplificateur faible bruit et les deux filtres.

Selon une autre particularité, l'anode de la première diode reliée par sa cathode au premier filtre, et la cathode de la deuxième diode reliée par son anode au deuxième filtre de la première respectivement deuxième paire de diodes sont connectées, d'une part sur l'antenne, respectivement sur l'entrée de l'amplificateur faible bruit, et d'autre part sur la sortie du comparateur par l'intermédiaire des deux liaisons comprenant alors chacune une self de choc, la cathode de la première diode et l'anode de la deuxième diode de chaque paire de diodes sont également connectées à la masse au travers de self de choc.

Selon une autre particularité, les commutateurs hyperfréquence de chaque ligne microruban du filtre comprennent une diode montée en série entre les deux portions de ligne microruban, la cathode de chaque diode est montée sur une première extrémité de la première portion de ligne microruban dont la deuxième extrémité est connectée à la masse et l'anode de chaque diode est connectée sur une première extrémité de la deuxième portion de ligne microruban dont la deuxième extrémité est connectée à la sortie du moyen de commande.

Ainsi, contrairement au dispositif décrit dans la demande de brevet GB 2 335 100, le dispositif selon l'invention n'a pas besoin de suivre la dérive en fréquence du canal d'émission, puisque la bande passante des deux filtres utilisés est beaucoup plus large que la bande passante du canal d'émission. En effet, dans l'exemple pris à titre d'illustration, la bande passante d'un canal d'émission est de 20MHz alors que la bande de fréquence de B1 est de 200Mhz et la bande de fréquence de B2 est de 255MHz.

L'invention, avec ses caractéristiques et avantages, ressortira plus clairement à la lecture de la description faite en référence aux dessins annexés dans lesquels :
- la figure 1 représente un schéma synoptique d'un système de réception des signaux hyperfréquences comprenant le dispositif de filtrage auto adaptatif selon l'invention.
- la figure 2 représente une variante des moyens de sélection des filtres du dispositif auto adaptatif selon l'invention,
- la figure 3 représente une variante d'un mode de réalisation des moyens de commutation des filtres du dispositif auto adaptatif selon l'invention,
- les figures 4A et 4B représentent une deuxième variante de réalisation des filtres du dispositif auto adaptatif selon l'invention ainsi, que les moyens de sélection appropriés.

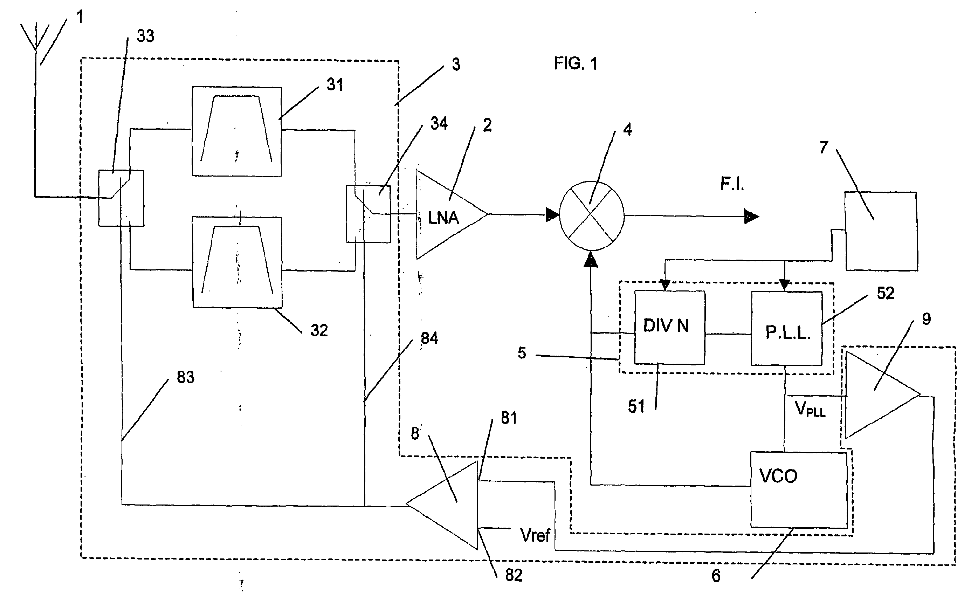

Le dispositif selon l'invention va à présent être décrit en référence à la figure 1. Le dispositif selon l'invention s'intègre, par exemple, dans un réseau domestique numérique sans fil. Plus particulièrement, le dispositif selon l'invention peut s'intégrer, soit dans la partie réception, soit dans la partie émission d'un système bidirectionnel permettant de déployer un réseau sans fil domestique tel qu'un réseau local radio de haute performance spécialement développé pour supporter des applications multimédia par un système de radio communication haut débit (jusqu'à 54Mbits/s dans une bande de fréquence de 5GHZ). Un tel système permet des liaisons de type point à point ou multipoints vers multipoints. Des bandes de fréquence spécifiques ont été allouées en Europe par le CEPT (Conférence Européenne des administrations des Postes et Télécommunications) et aux U.S.A. par le F.C.C (Federal Communication Commision).

Bande de fréquence en Europe: 5.15-5.35GHz est appelée B1 et 5.47-5.725GHz est appelée B2

Bande de fréquence aux USA: 5.15-5.35GHz et 5.725-5.825GHz

Les canaux sont espacés de 20Mhz dans chacune des sous bandes de fréquence et leurs fréquences centrales se déclinent de la façon suivante:

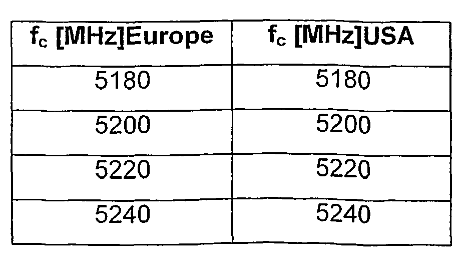

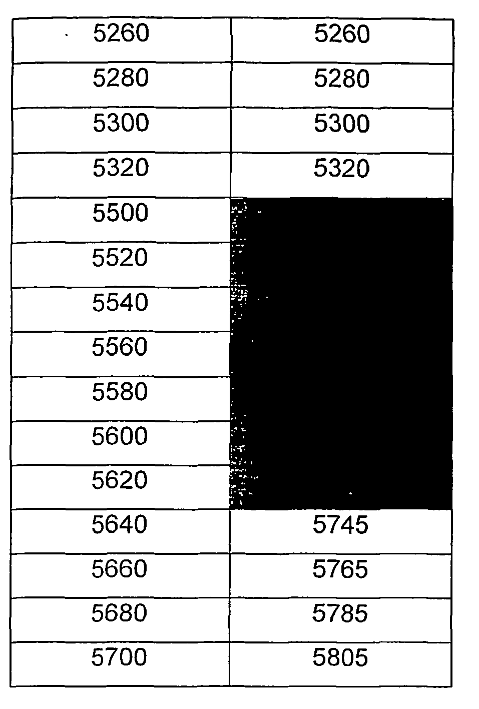

La partie réception d'un tel système comprend de manière connue une antenne (1) de réception transmettant le signal hyperfréquence reçu à l'entrée d'un amplificateur (2) à faible bruit, couramment appelé LNA (Low Noise Amplifier). Cet amplificateur (2) a pour fonction d'amplifier le signal représentatif de l'information transmise, par rapport au bruit également capté par l'antenne. Typiquement, l'amplificateur (2) à faible bruit est un amplificateur à bande de fréquence étroite accordé sur la bande de fréquence à recevoir. En sortie de l'amplificateur (2), le signal hyperfréquence amplifié est envoyé sur une entrée d'un mélangeur (4). Ce mélangeur (4) reçoit sur une autre entrée un signal d'un oscillateur (6) contrôlé en tension, couramment appelé VCO (Voltage Controlled Oscillator), commandé par un synthétiseur (5) de fréquence à boucle (52) de verrouillage de phase ou PLL (Phase Locked Loop). Le synthétiseur (5) de fréquence comprend également un diviseur de fréquence (51) commandé par un microprocesseur (7). Le synthétiseur (5) de fréquence permet d'ajuster la fréquence générée par l'oscillateur en fonction de la fréquence déterminée d'un canal choisi par le microprocesseur (7) permettant la réception d'informations. Le mélangeur (4) fournit alors en sortie un signal à une fréquence intermédiaire qui représente la ou les informations reçues. Ce signal à fréquence intermédiaire est ensuite décodé pour extraire la ou les informations reçues.

Selon l'art antérieur, et notamment selon la demande de brevet britannique GB 2 335 100, un filtre passe bande est disposé entre l'antenne et l'amplificateur à faible bruit pour limiter le spectre de fréquence reçu par l'amplificateur et ainsi, limiter la quantité de bruit reçue par l'amplificateur. Par conséquent, selon l'art antérieur, la bande de fréquence présentée à l'amplificateur est au moins comprise entre la plus petite fréquence allouée, et la plus grande fréquence allouée. Pour l'Europe, la bande de fréquence du filtre passe bande appliqué en amont de l'amplificateur serait comprise entre 5,15 et 5,725 GHz.

Selon l'invention, la largeur de bande de fréquence présentée à l'amplificateur est, dans l'exemple de l'Europe, soit la bande de fréquence B1, soit la bande de fréquence B2 en fonction de la fréquence du signal reçu sur l'antenne.

Ainsi, le dispositif (3) de filtrage auto adaptatif à bande de fréquence différentes selon l'invention, comprend deux filtres (31, 32), dont la bande passante correspond respectivement à la bande de fréquence B1 et à la bande de fréquence B2. Le dispositif (3) selon l'invention comprend également des moyens (8, 9, 33, 34) de sélection permettant d'utiliser soit le premier filtre (31) dont la bande passante correspond à la bande de fréquence B1, si la fréquence du signal à recevoir est comprise dans la bande de fréquence B1, soit le deuxième filtre (32) dont la bande de fréquence correspond à la bande de fréquence B2, si la fréquence du signal à recevoir est comprise dans la bande de fréquence B2. Les moyens de sélection comprennent deux commutateurs (33, 34) permettant de connecter entre l'antenne (1) et l'amplificateur faible bruit (2), soit le premier filtre (31), soit le deuxième filtre (32). Ces deux commutateurs (33, 34) sont contrôlés par des moyens (8, 9) de commande associés au synthétiseur (5) de fréquence. Ces moyens de commande comprennent un comparateur (8) recevant sur une première entrée (81), une tension (V_{PLL}) générée par la boucle (52) à verrouillage de phase. Cette tension (V_{PLL}) correspond en fait à l'image convertie en tension de la fréquence imposée par le synthétiseur (5) de fréquence à l'oscillateur (6) contrôlé en tension. Ainsi, l'information relative à la fréquence du signal à recevoir est constituée par cette tension (V_{PLL}). Le comparateur (8) reçoit sur une deuxième entrée (82), une tension (Vref) de référence. Le résultat de la comparaison entre la tension (Vref) de référence et la tension correspondant à l'image de la fréquence imposée à l'oscillateur (6), génère un signal de commande sur la sortie du comparateur (8). La sortie du comparateur (8) est connectée par l'intermédiaire de deux liaisons (83, 84) aux entrées de commande respectives de chacun des deux commutateurs (33, 34). Le signal de commande est tel que lorsque la tension (V_{PLL}) représentative de l'image de la fréquence imposée à l'oscillateur (6) correspond à une fréquence contenue dans la bande de fréquence B1, le signal de commande provoque une commutation des commutateurs (33, 34) sur le premier filtre (31). Si, au contraire, le signal de commande est tel que la tension représentative de l'image de la fréquence imposée à l'oscillateur (6) correspond à une fréquence contenue dans la bande de fréquence B2, le signal de commande provoque une commutation sur le deuxième filtre (32).

Le dispositif (3) selon l'invention comprend un circuit (9) de mise en forme (en anglais: buffer) connecté sur la première entrée (81) du comparateur (8). Le circuit (9) de mise en forme, par exemple constitué d'un amplificateur, a pour fonction de mettre en forme la tension (V_{PLL}) générée par la boucle (52) à verrouillage de phase avant de l'appliquer au comparateur.

Le dispositif selon l'invention fonctionne de la façon suivante. Deux cas de figures peuvent se présenter.

Dans un premier cas, une liaison est déjà établie sur un canal dont la fréquence est comprise dans l'une des bandes de fréquence allouées B1 ou B2. Pour une raison quelconque, par exemple, à cause d'interférences trop importantes sur le canal ou pour établir une liaison avec un autre émetteur, le signal hyperfréquence reçu sur l'antenne va contenir un signal induisant une commande de changement de canal. L'extraction de cette information du signal reçu va provoquer l'envoi d'une commande par le microprocesseur (7) vers le synthétiseur (5) de fréquence pour modifier la fréquence générée par l'oscillateur (6) afin qu'il se cale sur la fréquence du canal demandé. Si la fréquence du nouveau canal est comprise dans la même bande de fréquence que la fréquence du canal précédent, la tension (V_{PLL}) générée par la bouche (52) à verrouillage de phase n'entraînera pas de modification du signal de commande généré sur la sortie du comparateur (8). Par conséquent, les commutateurs (33, 34) ne changent pas d'état et le même filtre reste connecté. Si, au contraire, la fréquence du nouveau canal est comprise dans une bande de fréquence distincte du canal précédent, la tension (V_{PLL}) générée par la boucle (52) à verrouillage de phase entraîne une modification du signal de commande généré sur la sortie du comparateur (8). Par conséquent, les commutateurs (33, 34) changent d'état pour connecter l'amplificateur LNA (2) sur le filtre correspondant à la bande de fréquence dans laquelle est située la fréquence du nouveau canal.

Dans le deuxième cas de figure, le système numérique sans fil comprenant le dispositif selon l'invention est mis sous tension, mais n'a pas encore établi de liaison. Dans ce cas, une procédure d'initialisation est déclenchée par le microprocesseur (7), de sorte que ce dernier contrôle systématiquement tous les canaux des bandes de fréquence allouées pour décoder une onde porteuse indiquant qu'une information est transmise. Pour ce faire, le microprocesseur (7) va commander le synthétiseur (5) de fréquence pour balayer tous les canaux disponibles en commençant par un canal prédéterminé, par exemple en commençant par la fréquence la plus basse. Chaque canal est sélectionné pendant une durée déterminée pour vérifier si une porteuse est reçue sur le canal. Ainsi, pendant cette procédure de balayage des fréquences des canaux, tant que la fréquence du nouveau canal sélectionné est dans la même bande de fréquence que la fréquence du canal précédemment testé, le comparateur (8) n'entraîne pas de changement d'état des commutateurs (33, 34). Dans le cas contraire, tel que décrit dans le cas précédent, le comparateur entraîne la connexion sur le filtre adéquat. La procédure de balayage s'arrête dès qu'une porteuse est décodée sur l'un des canaux successivement sélectionnés.

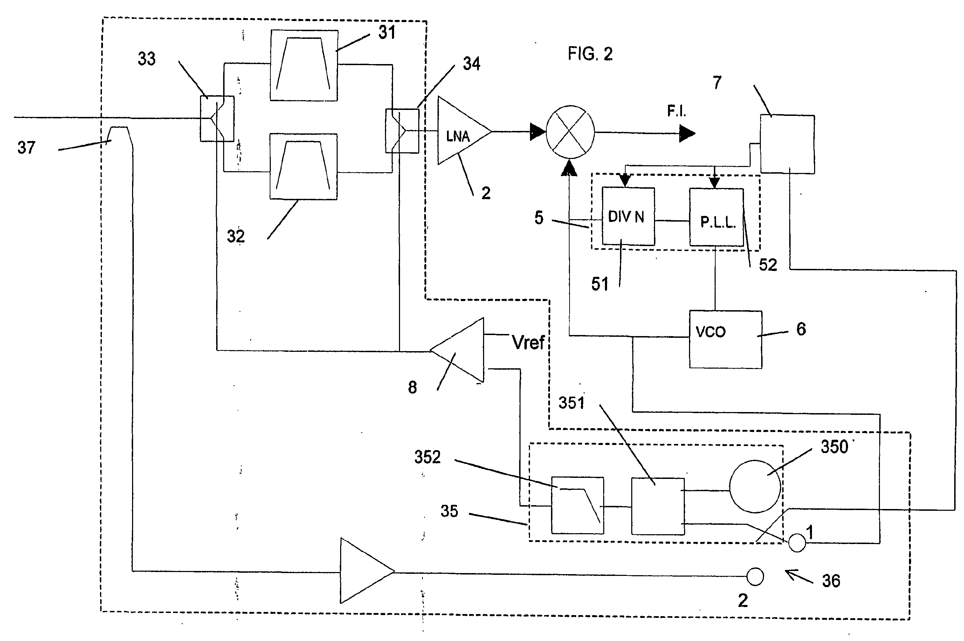

La figure 2 représente une variante des moyens de sélection des filtres du dispositif selon l'invention. La différence principale entre la variante représentée à la figure 1 et la variante de réalisation représentée à la figure 2 réside dans l'information utilisée pour modifier l'état des commutateurs. Ainsi, selon la figure 1, l'information utilisée est directement la tension de contrôle générée par le synthétiseur pour commander l'oscillateur. Selon la variante représentée à la figure 2, l'information utilisée est soit la fréquence de l'oscillateur (6), soit la fréquence du signal hyperfréquence capté par l'antenne. L'utilisation de l'une où l'autre des informations est déterminée par une commande générée par le microprocesseur (7).

Ainsi, le dispositif selon la variante représentée à la figure 2 comprend un circuit (35) de traitement dont la fonction est de convertir la fréquence utilisée comme information de commande en une tension appliquée sur la première entrée (81) du comparateur (8). Ce premier circuit comprend un comparateur (351) phase/fréquence, dont une première entrée reçoit un signal généré par un oscillateur (350) à fréquence fixe. La deuxième entrée du comparateur (351) phase/fréquence est reliée à un commutateur (36) commandé par le microprocesseur (7) permettant de connecter la deuxième entrée, soit dans une première position (P1), sur la sortie de l'oscillateur (6) contrôlé en tension, soit dans une deuxième position (P2) sur un coupleur (37) fournissant une image de la fréquence des signaux reçus sur l'antenne (1). Le comparateur (351) phase/fréquence génère sur sa sortie une tension de commande sur la première entrée (81) du comparateur (8) au travers d'un filtre (352) passe bas. Ainsi, lorsque le commutateur (36) commandé par le microprocesseur (7) est dans la première position (P1), le circuit (35) de traitement fournit sur la première entrée (81) du comparateur (8) l'image de la fréquence convertie en tension du signal hyperfréquence généré par l'oscillateur (6) contrôlé en tension pour commander, lors de l'établissement d'un choix, le calage du filtre auto adaptatif (31 à 34) sur une bande de fréquence incluant le canal choisi par le microprocesseur (7). Lorsque le commutateur (36) commandé par le microprocesseur (7) est dans la deuxième position (P2 le circuit (35) de traitement fournit sur la première entrée (81) du comparateur (8) l'image de la fréquence convertie en tension du signal hyperfréquence reçu par l'antenne, pour commander, lors d'un changement de canai, le calage du filtre auto adaptatif (31 à 34) sur la bande de fréquence incluant ce canal.

Le fonctionnement du dispositif selon la variante de réalisation représentée à la figure 2 est légèrement différent de celui du dispositif selon la variante de réalisation représentée à la figure 1. Les deux cas de figure définis se retrouvent dans la variante de la figure 2 mais sont traités différemment. Dans le premier cas de figure où une liaison est déjà établie, le microprocesseur (7) bascule le commutateur (36) sur la deuxième position(P2). Dans cette position, le comparateur (8) reçoit sur sa première entrée une tension correspondant à l'image de la fréquence des signaux reçus sur l'antenne. Si, dans le cas explicité précédemment, un canal de fréquence différente est sélectionné, le coupleur (37) va suivre le changement de fréquence du signal correspondant au changement de canal. Ainsi, si la fréquence du nouveau canal n'est pas dans la même bande de fréquence que le canal précédent, le comparateur va générer un signal de commande pour commuter d'un filtre à l'autre.

Dans le deuxième cas de figure où le système est mis sous tension, la phase d'initialisation du microprocesseur (7) débutera par l'envoi d'un signal de commande sur le commutateur (36) pour le faire basculer dans la première position P1. Dans cette position, le fonctionnement du dispositif selon la variante de la figure 2 est sensiblement le même que le dispositif de la figure 1, hormis le fait que le comparateur (8) ne reçoit pas directement la tension de commande envoyée par le synthétiseur de fréquence (5) à l'oscillateur (6) mais reçoit l'image convertie en tension des fréquences successives générées par l'oscillateur (6) contrôlé en tension.

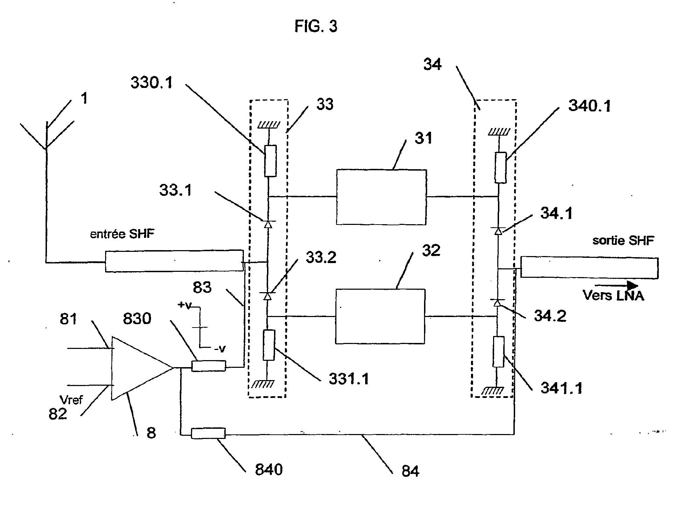

La figure 3 représente une variante des commutateurs. Selon cette variante, chaque commutateur (33, 34) comprend une paire de diodes (33.1, 33.2, 34.1, 34.2) en série, par exemple, de type PIN (P Intrinsèque N). La première paire de diodes (33.1, 33.2) correspond au commutateur monté entre l'antenne (1) et les deux filtres (31, 32) et la deuxième paire de diodes (34.1, 34.2) correspond au commutateur monté entre l'amplificateur (LNA) faible bruit (1) et les deux filtres (31, 32). L'anode de la première diode (33.1, respectivement 34.1) et la cathode de la deuxième diode (33.2, respectivement 34.2) de la première respectivement deuxième paire de diodes est connectée, d'une part sur l'antenne (1) respectivement sur l'entrée de l'amplificateur (LNA) faible bruit, et d'autre part sur la sortie du comparateur (8) par l'intermédiaire des deux liaisons (83, 84) comprenant alors chacune une self (830, 840) de choc. La cathode de la première diode (33.1, respectivement 34.1) est connectée d'une part au premier filtre (31) et l'anode de la deuxième diode (33.2, respectivement 34.2) de chaque paire de diodes est connectée d'autre part au deuxième filtre (32), enfin chaque diode est également reliée à la masse au travers de self de choc. Ainsi, lorsque le comparateur (8) délivre sur la sortie une tension positive (+V), les premières diodes (33.1, 34.1) de chaque paire de diodes sont polarisées dans le sens direct(passant) alors que les deuxièmes diodes (33.2, 34.2) de chaque paire de diodes sont polarisées dans le sens inverse(non passant). Par conséquent, le premier filtre (31), connecté entre les premières diodes (33.1, 34.1) de chaque paire de diodes, est sélectionné. Lorsque le comparateur (8) délivre sur la sortie une tension négative (-V), les deuxièmes diodes (33.2, 34.2) de chaque paire de diodes sont polarisées dans le sens direct alors que les premières diodes (33.1, 34.1) de chaque paire de diodes sont polarisées dans le sens inverse. Par conséquent, le deuxième filtre (32), connecté entre les deuxièmes diodes (33.2, 34.2) de chaque paire de diodes, est sélectionné.

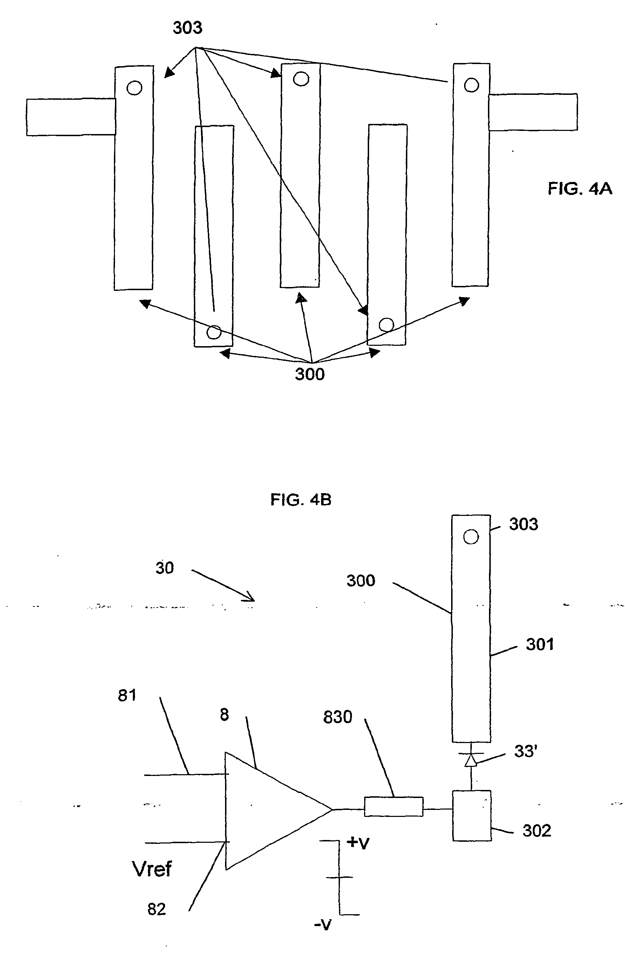

Les figures 4A et 4B représentent une variante de réalisation des filtres du dispositif selon l'invention ainsi que les moyens de sélection appropriés. Dans cette variante de réalisation, les filtres (31, 32) sont du type interdigité et sont composés de lignes microruban (301) de longueur déterminée et dont une première extrémité (303) comprend un trou métallisé connecté à la masse. Selon ce principe, en augmentant la longueur L de chaque ligne microruban (300) d'une longueur déterminée L1, on diminue la valeur de la fréquence centrale d'accord du filtre. Ainsi, les deux filtres utilisés dans les variantes représentées aux figures 1 à 3 sont remplacés par un filtre (30) à lignes microruban (300) dont chaque ligne microruban est divisée en deux portions (301, 302) séparées par des moyens (33') de sélection. Chaque première portion (301) de lignes microruban (300) est de longueur L déterminée. Chaque deuxième portion (302) est de longueur L1 déterminée. Les moyens (33') de sélection permettent d'allonger ou non la longueur de la première portion (301) de la longueur L1 de la deuxième portion (302). Les longueurs de la première et de la deuxième portions (301, 302) de chaque ligne microruban sont déterminées pour que le filtre (30) soit accordé sur la deuxième bande de fréquence B2 définie précédemment, lorsque la longueur L de toutes les lignes microruban (301) du filtre (30) correspond seulement à la longueur L de la première portion (301). Lorsque la longueur de toutes les lignes microruban (300) du filtre (30) correspond à la longueur L de la première portion (301) augmentée de la longueur L1 de la deuxième portion (302), alors le filtre (30) est accordé sur la première bande de fréquence B1 définie précédemment. La sélection de la première portion (301) ou de la première et de la deuxième portions (301, 302) de chaque ligne microruban (300) est réalisé par un commutateur (33') hyperfréquence commandé par le comparateur (8). Dans l'exemple de réalisation représenté à la figure 4B, chaque commutateur (33') hyperfréquence comprend une diode (33') montée en série entre les deux portions (301, 302) de lignes microruban. La cathode de chaque diode (33') est montée sur une première extrémité de la première portion (301) dont la deuxième extrémité est connectée à la masse. L'anode de chaque diode (33') est connectée sur une première extrémité de la deuxième portion (302) de lignes microruban dont la deuxième extrémité est connectée à la sortie du comparateur (8), par exemple au travers d'une self de choc (830). Ainsi, lorsque le comparateur délivre sur sa sortie une tension positive, chaque diode (33') est polarisée dans le sens direct (passant). Dans ce cas, le filtre (30) utilise une longueur de lignes microruban qui correspond à la longueur de la première portion (301) augmentée de la longueur de la deuxième portion (302). Par conséquent le filtre (30) est accordé sur la première bande de fréquence B1. Au contraire, lorsque le comparateur (8) délivre sur sa sortie une tension négative, chaque diode (33') est polarisée dans le sens inverse(non passant). Dans ce cas, seule la longueur de lignes microruban qui correspond seulement à la longueur de la première portion (301) est utilisée. Par conséquent, le filtre (30) est accordé sur la deuxième bande de fréquence B2. On peut ainsi réaliser facilement des filtres auto adaptatifs accordés sur différentes bandes de fréquence.

La description a été faite dans le but de son application à la partie réception, mais il est important de signaler que le dispositif de l'invention peut également être utilisé pour la partie émission où il peut être nécessaire de commuter entre deux filtres de bandes de fréquence différentes pour améliorer la réjection de l'oscillateur local et l'amélioration du spectre image. De même, l'invention peut s'appliquer à toute autre bande de fréquence, y compris pour des système utilisant plus de deux bandes de fréquence distinctes.

Il doit être évident pour les personnes versées dans l'art que la présente invention permet des modes de réalisation sous de nombreuses autres formes spécifiques sans l'éloigner du domaine d'application de l'invention comme revendiqué. Par conséquent, les présents modes de réalisation doivent être considérés à titre d'illustration mais peuvent être modifiés dans le domaine défini par la portée des revendications jointes.

## Revendications

1. Dispositif de filtrage passe bande auto adaptatif dans un récepteur de signaux hyperfréquences, relié à une antenne (1) de réception de signaux hyperfréquences et en aval à l'entrée d'un amplificateur (2) à faible bruit, à un mélangeur (4) recevant d'une part le signal de sortie de l'amplificateur (2) faible bruit, et d'autre part le signal d'un synthétiseur (5) de fréquence, et comprenant, au moins un moyen (300, 31, 32) de filtrage d' au moins deux bandes de fréquence différentes, et des moyens (8,9, 33, 33',34, 35) de sélection d'un moyen de filtrage (31, 32), d'une des bandes de fréquence en fonction de la fréquence du signal à recevoir **caractérisé en ce que** les moyens de sélection comportent des commutateurs (33, 33', 34) dont le changement d'état est déclenché par un moyen (8,9,35) de commande associé au synthétiseur (5) de fréquence.

2. Dispositif de filtrage passe bande auto adaptatif selon la revendication 1, **caractérisé en ce que** les moyens de filtrage comprennent deux filtres (31, 32) et les moyens de sélection comprennent une paire de commutateurs (33, 34) hyperfréquence entre deux états et disposée de part et d'autre de chaque filtre (31, 32) passe bande, de sorte que dans un premier état de la paire de commutateurs (33, 34), le signal reçu par l'antenne (1) est filtré par le premier filtre (31) et dans un deuxième état de la paire de commutateurs (33; 34), le signal reçu par l'antenne est filtré par le deuxième filtre (32).

3. Dispositif de filtrage passe bande auto adaptatif selon la revendication 1, **caractérisé en ce que** les deux filtres (31, 32) sont respectivement destinés au filtrage d'une première (B1) et deuxième (B2) bandes de fréquence.

4. Dispositif de filtrage passe bande auto adaptatif selon la revendication 2 ou 3, **caractérisé en ce que** les bandes de fréquence des moyens (31, 32) de filtrage sont disjointes.

5. Dispositif de filtrage passe bande auto adaptatif selon la revendication 1, **caractérisé en ce que** les moyens de filtrage comprennent un filtre (30) à lignes microruban (300) dont chaque ligne microruban est divisé en deux portions (301, 302) séparées, par les moyens (33') de commutation, chaque première et deuxième portions (301, 302) de lignes microruban (300) est de longueur déterminée pour que, lorsque les moyens de commutation autorisent le passage par couplage entre ligne microruban du signal reçu uniquement dans la première portion (301), le filtre soit accordé sur une première bande de fréquence et lorsque les moyens de commutation autorisent le passage par couplage entre lignes microruban du signal dans la première et la deuxième portions (301, 302), le filtre (30) soit accordé sur la deuxième bande de fréquence.

6. Dispositif de filtrage passe bande auto adaptatif selon l'une des revendications 1 à 5, **caractérisé en ce que** le moyen (8) de commande délivre un signal pour faire passer les commutateurs (33, 33', 34) dans le premier état lorsque la fréquence imposée par le synthétiseur (5) de fréquence est comprise dans une première bande de fréquence B1 des moyens de filtrage (30, 31, 32), , et le moyen (8) de commande délivre un signal pour faire passer les commutateurs (33, 33', 34) dans le deuxième état lorsque la fréquence imposée par le synthétiseur (5) de fréquence est comprise dans une deuxième bande de fréquence B2 des moyens de filtrage (30, 31, 32),.

7. Dispositif de filtrage passe bande auto adaptatif selon la revendication 5 ou 6, **caractérisé en ce que** le moyen de commande comprend un comparateur (8) dont une première entrée (81) est connectée au travers d'un étage tampon (9) au synthétiseur (5) de fréquence pour recevoir l'image convertie en tension de la fréquence produite par le synthétiseur de fréquence (5), et dont une deuxième entrée (82) reçoit une tension de référence (Vref) déterminée.

8. Dispositif de filtrage passe bande auto adaptatif selon la revendication 5 ou 6, **caractérisé en ce que** le moyen de commande comprend un comparateur (8) dont une première entrée (81) est connectée à un circuit (35) de traitement destiné à fournir une image convertie en tension, soit de la fréquence générée par l'oscillateur (6) contrôlé en tension, soit de la fréquence du signal hyperfréquence reçu par l'antenne (1).

9. Dispositif de filtrage passe bande auto adaptatif selon la revendication 7, **caractérisé en ce que** le circuit (35) de traitement comprend un comparateur (351) phase/fréquence, dont une première entrée reçoit un signal généré par un oscillateur (350) à fréquence fixe, la deuxième entrée du comparateur (351) phase/fréquence est reliée à un commutateur (36) commandé par le microprocesseur (7) permettant de connecter la deuxième entrée, soit dans une première position (P1), sur la sortie de l'oscillateur (6) contrôlé en tension, soit dans une deuxième position (P2), sur un coupleur (37) fournissant une image de la fréquence des signaux reçus sur l'antenne (1), la deuxième entrée (82) du comparateur (8) reçoit une tension de référence déterminée.

10. Dispositif de filtrage passe bande auto adaptatif selon l'une des revendication 1, à 8, **caractérisé en ce que** chaque commutateur (33, 34) comprend une paire de diodes rapides (33.1, 33.2, 34.1, 34.2) montées en série, de sorte qu'une première paire de diodes (33.1, 33.2) soit montée entre l'antenne (1) et les deux filtres (31, 32) et que la deuxième paire de diodes (34.1, 34.2) soit montée entre l'amplificateur (2) faible bruit (1) et les deux filtres (31, 32).

11. Dispositif de filtrage passe bande auto adaptatif selon la revendication 9, **caractérisé en ce que** l'anode de la première diode (33.1, respectivement 34.1) relié par sa cathode au premier filtre (31), et la cathode de la deuxième diode (33.2, respectivement 34.2) reliée par son anode au deuxième filtre (32) de la première respectivement deuxième paire de diodes sont connectées, d'une part sur l'antenne (1), respectivement sur l'entrée de l'amplificateur (2) faible bruit, et d'autre part sur la sortie du comparateur (8), par l'intermédiaire des deux liaisons (83, 84) comprenant alors chacune une self (830, 840) de choc, la cathode de la première diode (33.1, respectivement 34.1) et l'anode de la deuxième diode (33.2, respectivement 34.2) de chaque paire de diodes sont également connectées à la masse au travers de self de choc (330.1, 340.1, 331.1, 341.1).

12. Dispositif de filtrage passe bande auto adaptatif selon la revendication 5, **caractérisé en ce que** les commutateurs hyperfréquence de chaque ligne microruban du filtre (30) comprennent une diode (33') montée en série entre les deux portions (301, 302) de lignes microruban, la cathode de chaque diode (33') est montée sur une première extrémité de la première portion (301) de lignes microruban (300) dont la deuxième extrémité est connectée à la masse et l'anode de chaque diode (33') est connectée sur une première extrémité de la deuxième portion (302) de lignes microruban dont la deuxième extrémité est connectée à la sortie du moyen de commande (8).

13. Emetteur /récepteur de signaux hyperfréquences **caractérisé en ce qu'**il comporte le dispositif de filtrage passe bande auto adaptatif selon l'une des revendications 1 à 12.

## Claims

1. Self-adaptive band-pass filtering device in a microwave signal receiver, the receiver being connected to a microwave signal receiving antenna (1) and connected upsteam to the input of a low-noise amplifier (2), to a mixer (4) that receives, on the one hand, the output signal of the low-noise amplifier (2) and, on the other hand, the signal from a frequency synthesizer (5), to at least one filtering means (300, 31, 32) having at least two different frequency bands and to means (8,9, 33, 33', 34, 35) for selecting a filtering means (31, 32) of one of the frequency bands depending on the frequency of the signal to be received **characterized in that** the means for selecting self-adaptive filtering device (3) comprises switches means, upstream of the amplifier (2), **characterized in that** the means for selecting comprise switches (33, 33 ', 34) whose change of state is started by a control means (8,9,35) associated with the frequency synthetizer (5).

2. Self-adaptive band-pass filtering device according to Claim 1, **characterized in that** the filtering means comprise two filters (31, 32) and the selection means comprise a pair of microwave switches (33, 34) switching between two states, the said pair of switches being placed on each side of each band-pass filter (31, 32), so that, in a first state of the pair of switches (33, 34) the signal received by the antenna (1) is filtered by the first filter (31) and in a second state of the pair of switches (33, 34) the signal received by the antenna is filtered by the second filter (32).

3. Self-adaptive band-pass filtering device according to Claim 1, **characterized in that** the two filters (31, 32) are intended for filtering a first frequency band (B1) and a second frequency band (B2), respectively.

4. Self-adaptive band-pass filtering device according to Claim 2 or 3, **characterized in that** the frequency bands of the filtering means (31, 32) are separated.

5. Self-adaptive band-pass filtering device according to Claim 1, **characterized in that** the filtering means comprise a filter (30) based on microstrip lines (300), each microstrip line of which is divided into two separate portions (301, 302) by the switching means (33'), each of the first and second portions (301, 302) of the microstrip lines (300) being of a length defined so that when the switching means allow the received signal to pass, by coupling between microstrip lines, only into the first portion (301) the filter is tuned to a first frequency band, and when the switching means allow the signal to pass, by coupling between microstrip lines, into the first and second portions (301, 302) the filter (30) is tuned to the second frequency band.

6. Self-adaptive band-pass filtering device according to one of Claims 2 to 5, **characterized in that** the control means (8) delivers a signal for making the switches (33, 33 ', 34) pass into the first state when the frequency imposed by the frequency synthesizer (5) so that when the frequency imposed by the frequency synthesizer (5) lies within a first frequency band B1 of the filtering means (30, 31, 32) and the control means (8) delivers a signal for making the switches (33, 33', 34) pass into the second state when the frequency imposed by the frequency synthesizer (5) lies within a second frequency band B2 of the filtering means (30, 31, 32).

7. Self-adaptive band-pass filtering device according to Claim 5 or 6, **characterized in that** the control means comprises a comparator (8), a first input (81) of which is connected via a buffer stage (9) to the frequency synthesizer (5) in order to receive the voltage-converted image of the frequency produced by the frequency synthesizer (5) and a second input (82) of which receives a defined reference voltage (V_{ref}).

8. Self-adaptive band-pass filtering device according to Claim 5 or 6, **characterized in that** the control means comprises a comparator (8), a first input (81) of which is connected to a processing circuit (35) intended to deliver a voltage-converted image either of the frequency generated by the voltage-controlled oscillator (6) or of the frequency of the microwave signal received by the antenna (1).

9. Self-adaptive band-pass filtering device according to Claim 7, **characterized in that** the processing circuit (35) comprises a phase/frequency comparator (351), a first input of which receives a signal generated by a fixed-frequency oscillator (350), the second input of the phase/frequency comparator (351) is connected to a switch (36) controlled by the microprocessor (7), making it possible to connect the second input either, in a first position (P1), to the output of the voltage-controlled oscillator (6) or, in a second position (P2), to a coupler (37) delivering an image of the frequency of the signals received on the antenna (1), and the second input (82) of the comparator (8) receives a defined reference voltage.

10. Self-adaptive band-pass filtering device according to one of Claims 1 to 8, **characterized in that** each switch (33, 34) comprises a pair of high-speed diodes (33.1, 33.2, 34.1, 34.2) mounted in series so that a first pair of diodes (33.1, 33.2) is mounted between the antenna (1) and the two filters (31, 32) and the second pair of diodes (34.1, 34.2) is mounted between the low-noise amplifier (2) and the two filters (31, 32).

11. Self-adaptive band-pass filtering device according to Claim 9, **characterized in that** the anode of the first diode (33.1, respectively 34.1), connected via its cathode to the first filter (31), and the cathode of the second diode (33.2, respectively 34.2), connected via its anode to the second filter (32), of the first and second pair of diodes respectively are connected, on the one hand, to the antenna (1) and to the input of the low-noise amplifier (2) respectively and, on the other hand, to the output of the comparator (8) via the two links (83, 84) which then each include a shock inductor (830, 840), the cathode of the first diode (33.1, respectively 34.1) and the anode of the second diode (33.2, respectively 34.2) of each pair of diodes being also connected to earth through the shock inductor (330.1, 340.1, 331.1, 341.1).

12. Self-adaptive band-pass filtering device according to Claim 5, **characterized in that** the microwave switches of each microstrip line of the filter (30) include a diode (33') mounted in series between the two portions (301, 302) of the microstrip lines, the cathode of each diode (33') is connected to a first end of the first portion (301) of the microstrip lines (300), the second end of which is connected to earth, and the anode of each diode (33') is connected to a first end of the second portion (302) of the microstrip lines, the second end of which is connected to the output of the control means (8).

13. Microwave signal transmitter/receiver **characterized in that** it comprises the self-adaptive band-pass frequency-filtering device according to one of claims 1 to 12.

## Patentansprüche

1. Selbstabgleichende Bandpassfilterungsvorrichtung in einem Empfänger von Mikrowellensignalen, welche mit einer Antenne (1) für den Empfang von Mikrowellensignalen und danach mit dem Eingang eines rauscharmen Verstärkers (2) sowie mit einem Mischer (4), der zum einen das Ausgangssignal des rauscharmen Verstärkers (2) und zum anderen das Signal eines Frequenzsynthesizers (5) empfängt, verbunden ist und mindestens ein Mittel (300, 31, 32) zur Filterung von mindestens zwei verschiedenen Frequenzbändern und Mittel (8, 9, 33, 33', 34, 35) zur Auswahl eines Mittels (31, 32) zur Filterung eines der Frequenzbänder in Abhängigkeit von der Frequenz des zu empfangenden Signals aufweist, **dadurch gekennzeichnet, dass** die Auswahlmittel Schalter (33, 33', 34) aufweisen, deren Zustandswechsel von einem Steuerungsmittel (8, 9, 35) ausgelöst wird, das dem Frequenzsynthesizer (5) zugeordnet ist.

2. Selbstabgleichende Bandpassfilterungsvorrichtung nach Anspruch 1, **dadurch gekennzeichnet, dass** die Filtermittel zwei Filter (31, 32) umfassen und die Auswahlmittel ein Paar Mikrowellenschalter (33, 34) umfassen, die zwischen zwei Zuständen umschaltbar und auf der einen und der anderen Seite von jedem Bandpassfilter (31, 32) angeordnet sind, so dass in einem ersten Zustand des Schalterpaars (33, 34) das von der Antenne (1) empfangene Signal von dem ersten Filter(31) gefiltert wird und in einem zweiten Zustand des Schalterpaars (33, 34) das von der Antenne empfangene Signal von dem zweiten Filter (32) gefiltert wird.

3. Selbstabgleichende Bandpassfilterungsvorrichtung nach Anspruch 1, **dadurch gekennzeichnet, dass** die zwei Filter (31, 32) jeweils für die Filterung eines ersten Frequenzbandes (B1) und eines zweiten Frequenzbandes (B2) bestimmt sind.

4. Selbstabgleichende Bandpassfilterungsvorrichtung nach Anspruch 2 oder 3, **dadurch gekennzeichnet, dass** die Frequenzbänder der Filtermittel (31, 32) disjunkt sind.

5. Selbstabgleichende Bandpassfilterungsvorrichtung nach Anspruch 1, **dadurch gekennzeichnet, dass** die Filtermittel ein Filter (30) mit Mikrostreifenleitungen (300) umfassen, bei dem jede Mikrostreifenleitung durch die Schaltmittel (33') in zwei getrennte Abschnitte (301, 302) geteilt ist, wobei jeder erste und zweite Abschnitt (301, 302) der Mikrostreifenleitungen (300) eine bestimmte Länge aufweist, damit das Filter auf ein erstes Frequenzband abgestimmt wird, wenn die Schaltmittel durch Kopplung zwischen Mikrostreifenleitungen den Durchgang des lediglich in dem ersten Abschnitt (301) empfangenen Signals zulassen, und das Filter (30) auf das zweite Frequenzband abgestimmt wird, wenn die Schaltmittel durch Kopplung zwischen Mikrostreifenleitungen den Durchgang des Signals in dem ersten und in dem zweiten Abschnitt (301, 302) zulassen.

6. Selbstabgleichende Bandpassfilterungsvorrichtung nach einem der Ansprüche 1 bis 5, **dadurch gekennzeichnet, dass** das Steuerungsmittel (8) ein Signal abgibt, um die Schalter (33, 33', 34) in den ersten Zustand zu versetzen, wenn die von dem Frequenzsynthesizer (5) vorgegebene Frequenz in einem ersten Frequenzband (B1) der Filtermittel (30, 31, 32) enthalten ist, und das Steuerungsmittel (8) ein Signal abgibt, um die Schalter (33, 33', 34) in den zweiten Zustand zu versetzen, wenn die von dem Frequenzsynthesizer (5) vorgegebene Frequenz in einem zweiten Frequenzband (B2) der Filtermittel (30, 31, 32) enthalten ist.

7. Selbstabgleichende Bandpassfilterungsvorrichtung nach Anspruch 5 oder 6, **dadurch gekennzeichnet, dass** das Steuerungsmittel einen Komparator (8) umfasst, von dem ein erster Eingang (81) über eine Pufferstufe (9) mit dem Frequenzsynthesizer (5) verbunden ist, um die in eine Spannung umgewandelte Abbildung der von dem Frequenzsynthesizer (5) erzeugten Frequenz zu empfangen, und von dem ein zweiter Eingang (82) eine bestimmte Referenzspannung (Vref) empfängt.

8. Selbstabgleichende Bandpassfilterungsvorrichtung nach Anspruch 5 oder 6, **dadurch gekennzeichnet, dass** das Steuerungsmittel einen Komparator (8) umfasst, von dem ein erster Eingang (81) mit einer Verarbeitungsschaltung (35) verbunden ist, die dazu bestimmt ist, eine in eine Spannung umgewandelte Abbildung entweder der von dem spannungskontrollierten Oszillator (6) erzeugten Frequenz oder der Frequenz des von der Antenne (1) empfangenen Mikrowellensignals zu liefern.

9. Selbstabgleichende Bandpassfilterungsvorrichtung nach Anspruch 7, **dadurch gekennzeichnet, dass** die Verarbeitungsschaltung (35) einen Phase-Frequenz-Komparator (351) umfasst, von dem ein erster Eingang ein von einem Festfrequenzoszillator (350) erzeugtes Signal empfängt, der zweite Eingang des Phase-Frequenz-Komparators (351) mit einem Schalter (36) verbunden ist, der von dem Mikroprozessor (7) gesteuert ist, der den Anschluss des zweiten Eingangs entweder in einer ersten Position (P1) an den Ausgang des spannungskontrollierten Oszillators (6) oder in einer zweiten Position (P2) an einen Koppler (37), der eine Abbildung der Frequenz der an der Antenne (1) empfangenen Signale liefert, ermöglicht, wobei der zweite Eingang (82) des Komparators (8) eine bestimmte Referenzspannung erhält.

10. Selbstabgleichende Bandpassfilterungsvorrichtung nach einem der Ansprüche 1 bis 8, **dadurch gekennzeichnet, dass** jeder Schalter (33, 34) ein Paar von in Serie geschalteten schnellen Dioden (33.1, 33.2, 34.1, 34.2) umfasst, derart dass ein erstes Paar von Dioden (33.1, 33.2) zwischen der Antenne (1) und den zwei Filtern (31, 32) geschaltet ist und das zweite Paar von Dioden (34.1, 34.2) zwischen dem rauscharmen (1) Verstärker (2) und den zwei Filtern (31, 32) geschaltet ist.

11. Selbstabgleichende Bandpassfilterungsvorrichtung nach Anspruch 9, **dadurch gekennzeichnet, dass** die Anode der ersten Diode (33.1 beziehungsweise 34.1), die über ihre Kathode mit dem ersten Filter (31) verbunden ist, und die Kathode der zweiten Diode (33.2 beziehungsweise 34.2), die über ihre Anode mit dem zweiten Filter (32) des ersten beziehungsweise des zweiten Paars von Dioden verbunden ist, zum einen an die Antenne (1) beziehungsweise an den Eingang des rauscharmen Verstärkers (2) und zum anderen über die zwei dann jeweils eine Drossel (830, 840) umfassenden Verbindungen (83, 84) an den Ausgang des Komparators (8) angeschlossen sind, wobei die Kathode der ersten Diode (33.1 beziehungsweise 34.1) und die Anode der zweiten Diode (33.2 beziehungsweise 34.2) jedes Paars von Dioden ebenfalls an die Masse über Drosseln (330.1, 340.1, 331.1, 341.1) angeschlossen sind.

12. Selbstabgleichende Bandpassfilterungsvorrichtung nach Anspruch 5, **dadurch gekennzeichnet, dass** die Mikrowellenschalter jeder Mikrostreifenleitung des Filters (30) eine Diode (33') umfassen, die zwischen den zwei Abschnitten (301, 302) der Mikrostreifenleitungen in Serie geschaltet sind, wobei die Kathode jeder Diode (33') an einem ersten Ende des ersten Abschnitts (301) der Mikrostreifenleitungen (300) angebracht ist, dessen zweites Ende an die Masse angeschlossen ist, und die Anode jeder Diode (33') an ein erstes Ende des zweiten Abschnitts (302) der Mikrostreifenleitungen angeschlossen ist, dessen zweites Ende an den Ausgang des Steuerungsmittels (8) angeschlossen ist.

13. Sende-Empfangsgerät von Mikrowellensignalen, **dadurch gekennzeichnet, dass** es die selbstabgleichende Bandpassfilterungsvorrichtung nach einem der Ansprüche 1 bis 12 aufweist.
